# FASCICULE DE BREVET EUROPEEN

(11) **EP 2 004 881 B1**
(45) Date de publication et mention de la délivrance du brevet: **18.10.2017**
(21) Numéro de dépôt: 07701925.5
(22) Date de dépôt: 08.03.2007
(51) Int. Cl.: G04D 3/00, G03F 7/40, G04B 29/02, C25D 1/08

(54) **PROCEDE DE FABRICATION PAR LIGA-UV D'UNE STRUCTURE METALLIQUE MULTICOUCHE A COUCHES ADJACENTES NON ENTIEREMENT SUPERPOSEES, ET STRUCTURE OBTENUE**
VERFAHREN ZUR HERSTELLUNG VON LIGA-UV-MEHRHSCHICHTMETALLSTRUKTUREN, WOBEI DIE SCHICHTEN BENACHBART UND NICHT VOLLSTÄNDIGER ÜBERLAGERT SIND, UND STRUKTUR DARAUS
PROCESS FOR THE FABRICATION OF LIGA-UV MULTILAYER METALLIC STRUCTURES, THE LAYERS BEING ADJACENT AND NOT COMPLETELY SUPERIMPOSED, AND STRUCTURE THEREFROM.

(30) Priorité: 15.03.2006 EP 06405115
(43) Date de publication de la demande: 24.12.2008
(73) Titulaire: ROLEX SA, 1211 Genève 26 (CH)
(72) Inventeur: SAUCY, Clément, CH-2520 La Neuveville (CH)
(74) Mandataire: Moinas & Savoye SARL
(86) Numéro de dépôt international: PCT/CH2007/000126
(87) Numéro de publication internationale: WO 2007/104171

(56) Documents cités:
- EP-A- 0 567 332
- EP-A- 0 851 295
- WO-A-2005/054547
- US-A- 5 234 571
- US-A1- 2004 144 653
- US-B1- 6 458 263
- A. B. FRAZIER, M. G. ALLEN: "Metallic Microstructures Fabricated Using Photosensitive Polyimide Electroplating Molds" JOURNAL OF MICROELECTROMECHANICAL SYSTEMS, vol. 2, no. 2, juin 1993 (1993-06), pages 87-94, XP008067133 cité dans la demande

## Description

La présente invention concerne un nouveau procédé de fabrication par LIGA-UV d'une structure métallique multicouche à couches adjacentes non entièrement superposées, ainsi qu'une nouvelle structure métallique multicouche à couches adjacentes non entièrement superposées susceptible d'être obtenue par ce procédé.

DGC Mitteilungen No. 104, 2005, mentionne l'utilisation de la technologie LIGA (LIthographie Galvanik Abformung: méthode conçue par W. Ehrfeld du Karlsruhe Nuclear Research Center, Allemagne) pour la fabrication de pièces métalliques horlogères de haute précision, telles que par exemple des ancres ou des roues d'échappement. Ce procédé présente l'inconvénient de nécessiter un équipement lourd, un synchrotron, pour générer l'irradiation en rayons X. Il ne peut donc être commodément utilisé dans l'industrie horlogère.

A.B. Frazier et al., Journal of Microelectromechanical systems, 2, 2, June 1993, décrit la fabrication de structures métalliques par électrodéposition de métal dans des moules en photorésist à base de polyimide, préparés à l'aide d'un procédé utilisant une technologie appelée LIGA-UV, analogue à la technologie LIGA mais avec une illumination UV à la place de l'irradiation aux rayons X.

Le procédé utilisé pour la fabrication de ces structures métalliques comprend les étapes suivantes :
- créer sur une plaquette support en silicium une couche métallique sacrificielle et une couche d'ensemencement pour l'électrodéposition,
- étaler par dépôt à la tournette (spin-coating) une couche de polyimide photosensible,
- effectuer à travers un masque correspondant à l'empreinte désirée une illumination aux rayons ultraviolets,
- développer en dissolvant les parties non irradiées de façon à obtenir un moule en polyimide,
- déposer galvaniquement du nickel dans la partie ouverte du moule jusqu'à hauteur de celui-ci de façon à obtenir une surface supérieure sensiblement plane,
- déposer par vaporisation sous vide une couche fine de chrome,
- déposer sur cette couche fine de chrome une couche de polyimide photosensible par dépôt à la tournette (spin-coating), - effectuer une illumination UV à travers un nouveau masque correspondant à l'empreinte désirée, développer en dissolvant les parties non irradiées de façon à obtenir un nouveau moule en polyimide, enlever la couche fine de chrome dans la partie ouverte du moule avec une solution d'acide chlorhydrique et déposer galvaniquement du nickel dans la partie ouverte du moule, et
- éliminer la couche sacrificielle et séparer la structure métallique obtenue par électrodéposition du moule en polyimide.

Ce procédé est utilisé pour fabriquer une plaque métallique surmontée d'une protubérance de forme générale parallélépipédique (V. et Fig.9 page 92), la deuxième couche étant entièrement superposée sur la première couche de surface plus grande. Il est mentionné (dernier paragraphe du V. page 93) que la même structure inversée avec la protubérance de forme générale parallélépipédique en-dessous de la plaque a également été fabriquée selon la même technique, mais la structure effectivement obtenue n'est ni montrée, ni décrite.

La demanderesse a constaté que la mise en oeuvre d'un tel procédé lorsque la deuxième couche déposée par voie électrolytique n'est pas entièrement superposée sur la première couche, conduit à une croissance non verticale du métal déposé et à la formation de bulles au-dessus de la résine.

EP-0851295 divulgue un autre procédé de fabrication par LIGA-UV de structures métalliques multicouches proche du procédé enseigné par Frazier et al., appliqué à la fabrication d'une roue dentée surmontée d'un pignon bicouche à couches entièrement superposées (Exemple 1) ou d'un microcapteur de flux thermique tricouche à couches entièrement superposées (Exemple 3). Si ce procédé était utilisé pour fabriquer une structure comportant deux couches adjacentes non entièrement superposées, il présenterait aussi les inconvénients exposés ci-dessus.

On a encore proposé dans le US 2004/0144653 un procédé de fabrication de micro-structures sur un substrat formé d'une plaquette de verre de céramique ou de semi-conducteur. Cette micro-structure comprend un organe de base sur lequel un organe de support est formé sélectivement par électroformage pour supporter une micro plate-forme. Le procédé se rapporte aussi à l'électroformage sélectif de la micro plate-forme et à la formation d'organes d'articulation flexible pour relier la micro plate-forme au support et permettre un mouvement relatif entre eux.

La nature du substrat utilisé pour réaliser cette micro-structure est trop fragile pour permettre de réaliser des mises d'épaisseur des différentes couches par usinage. Or, il s'avère que la qualité de la ou des couches ultérieures déposées n'est pas aussi bonne si la couche de base n'est pas parfaitement plane et polie.

D'autre part, il s'avère que les structures métalliques obtenues ne peuvent pas être séparées du substrat sans être séparées les unes des autres. Or si on doit notamment enlever la résine d'un trou borgne ou d'une autre partie difficile d'accès qui se situe notamment sur l'avers de la structure, on ne peut l'enlever que dans un bain de solvant, méthode qui ne garantit pas de vider complètement le trou borgne de sa résine.

Le problème ou but de l'invention est de trouver un procédé de fabrication d'une structure métallique multicouche comportant au moins deux couches adjacentes non entièrement superposées, qui remédie au moins en partie à ces inconvénients.

Ce problème est résolu par l'invention telle que définie par les revendications.

L'invention concerne ainsi un procédé de fabrication par LIGA-UV d'une structure métallique multicouche comportant une première couche ayant un trou ou un dégagement, au moins une deuxième couche adjacente à une première couche, non entièrement superposée à celle-ci et surplombant ledit trou ou dégagement, qui comprend les étapes suivantes :
a) étaler une couche de photorésist sur un substrat plat en métal massif,
b) chauffer la couche de photorésist, si nécessaire pour évaporer le solvant,
c) exposer la couche de photorésist à travers un masque correspondant à l'empreinte désirée à une irradiation,
d) effectuer, si nécessaire pour compléter la photopolymérisation ou la photodécomposition des parties irradiées, un recuit de la couche obtenue à l'issue de l'étape c),
e) procéder au développement par dissolution des parties non photopolymérisées ou photodécomposées, de façon à obtenir un moule de photorésist polymérisé,
f) déposer galvaniquement une première couche d'un métal ou d'un alliage dans les parties ouvertes du moule, et mettre à niveau par usinage la structure métallique,
g) reproduire les étapes a), b), c), d) et e),
h) déposer galvaniquement une deuxième couche (16) d'un métal ou d'un alliage, et mettre à niveau par usinage la structure métallique et le moule de façon à obtenir une surface supérieure plane,
i) reproduire, si nécessaire, les étapes g) et h), de façon à former la structure métallique multicouche souhaitée, et
j) détacher du substrat par délaminage la structure métallique multicouche obtenue et le photorésist polymérisé, séparer le photorésist de façon à libérer la structure métallique multicouche,
ce procédé étant caractérisé en ce que
- à l'étape c), l'irradiation est une irradiation UV de 100 à 2000 mJ/cm² mesurée à une longueur d'onde de 365 nm,
- à l'étape f), la mise à niveau s'effectue avec le moule, puis une couche métallique d'accrochage est déposée par vaporisation sous vide sur toute la surface supérieure plane et
- à la fin de l'étape j), on élimine la partie de la ou des couches métalliques d'accrochage qui n'est pas insérée entre deux couches de métal électrodéposé.

L'expression "une deuxième couche adjacente à une première couche et non entièrement superposée à celle-ci" signifie que le contour de la deuxième couche ne rentre pas entièrement dans l'élévation verticale du contour de la première couche.

La plaquette métallique massive formant le substrat a une épaisseur en général de 1 à 5 mm, formée d'un métal et/ou d'un alliage conducteur apte à ensemencer (démarrer) la réaction d'électroformage en jouant le rôle de cathode. Cette plaquette peut par exemple être constituée de cuivre, de laiton ou d'acier inoxydable. De préférence elle est constituée d'acier inoxydable.

La surface supérieure de la plaquette métallique massive, destinée à être en contact avec le bain électrolytique, peut être polie ou texturée par exemple par microbillage, gravage chimique, mécanique ou par laser.

La plaquette métallique massive est dégraissée et préparée pour l'électroformage par un traitement approprié. Lorsqu'elle est constituée d'acier inox, un traitement approprié consiste par exemple à opérer un dégraissage avec une solution alcaline, suivi d'une neutralisation en milieu acide pour passiver sa surface, rincer à l'eau distillée et sécher.

Le photorésist est soit un photorésist négatif, à base d'une résine susceptible de polymériser sous l'action du rayonnement UV en présence d'un photo initiateur, soit un photorésist positif, à base d'une résine susceptible de se décomposer sous l'action du rayonnement UV en présence d'un photo initiateur. Le photorésist négatif est par exemple à base d'une résine époxy, d'une résine isocyanate ou d'une résine acrylique. Une résine époxy avantageuse est la résine époxy octofonctionelle SU-8 (Shell Chemical). Elle est utilisée en général en présence d'un photo initiateur choisi parmi les sels de triarylsulfonium, par exemples ceux décrits dans les brevets US 4,058,401 et 4,882,245. Le photorésist positif est par exemple à base d'une résine phénolformaldéhydique de type novalaque en présence d'un photo initiateur DNQ (DiazoNaphtoQuinone).

L'étalement du photorésist peut se faire par dépôt à la tournette (« spin-coating ») ou par une autre technique, telle que par exemple le trempage (« dip coating »), l'application au cylindre (« roller coating »), l'enduction par extrusion-laminage (« extrusion coating »), le revêtement par pulvérisation (« spray coating ») ou encore le laminage (pour les films secs, par exemple à base de résine acrylique). La technique d'étalement préférée est le dépôt à la tournette.

L'épaisseur maximale de photorésist pour induire l'effet recherché (photo polymérisation ou photo décomposition) dans les conditions d'irradiation de l'étape c) est de 1 mm. L'épaisseur maximale de la couche de photorésist qu'on peut étaler en une fois est typiquement de 150 µm selon la technique de dépôt à la tournette. Selon l'épaisseur souhaitée du photorésist, on étalera celui-ci sur le substrat métallique massif en une ou plusieurs fois.

Les conditions de chauffage éventuel du photorésist pour éliminer le solvant dans l'étape b) sont choisies en fonction de la nature et de l'épaisseur du photorésist selon les indications de son fabricant. Pour un photorésist à base d'une résine époxy SU-8 et d'épaisseur 140 µm, l'étape b) consiste par exemple à chauffer à 65 °C pendant 5 à 10 minutes, puis à 95 °C pendant une durée de 30 à 60 minutes. Pour un photorésist à base de film sec acrylique, cette étape de chauffage pour évaporer le solvant n'est pas nécessaire.

Dans le cas où il est nécessaire d'étaler le photorésist en plusieurs fois et de chauffer le photorésist pour évaporer le solvant, on effectuera l'étape b) à l'issue de l'étape a) après le premier étalement du photorésist et on reproduira les étapes a) et b) le nombre de fois nécessaire.

L'étape c) consiste à exposer la couche de photorésist à travers un masque correspondant à l'empreinte désirée à une irradiation UV de 100 à 2000 mJ/cm² mesurée à une longueur d'onde de 365 nm. Cette irradiation induit la photo polymérisation de la résine (photorésist négatif) ou la photo décomposition de celle-ci (photorésist positif).

L'étape d) consiste à effectuer, si nécessaire pour compléter la photo polymérisation ou la photo décomposition de l'étape c), un recuit de la couche obtenue à l'issue de cette étape. Pour certains photorésists, par exemple les photorésists à base de film sec acrylique, cette étape de chauffage pour compléter la photo polymérisation n'est pas nécessaire.

L'étape e) consiste à procéder au développement par dissolution des parties non irradiées (photorésist négatif) ou des parties irradiées (photorésist positif) à l'aide d'une solution aqueuse appropriée ou d'un solvant, choisi en fonction de la nature du photorésist selon les indications de son fabricant. Des exemples de solutions aqueuses appropriées sont des solutions alcalines de base faible, par exemple de carbonate de sodium, et des exemples de solvants appropriés sont le GBL (gammabutyrolactone), le PGMEA (propylène glycol méthyle éthyle acétate), et l'isopropanol. On utilise avantageusement comme solvant ou solution de développement pour la résine époxy SU-8 du PGMEA, et pour une résine acrylique une solution de carbonate de sodium 1 % ou de l'isopropanol.

L'étape f) consiste à déposer galvaniquement une première couche d'un métal ou d'un alliage dans les parties ouvertes du moule de photorésist, et usiner une surface supérieure sensiblement plane.

Avec le substrat formé d'une plaquette métallique massive, il est possible d'usiner la structure métallique et le moule sur le substrat et donc de les mettre à niveau de façon à obtenir une surface supérieure plane au niveau voulu. Il n'est donc alors plus nécessaire de surveiller avec une grande précision la montée du métal électroformé dans le moule. On choisit ce niveau un peu en dessus de l'épaisseur visée (de 10 à 30 µm), et on met ensuite à niveau par usinage, notamment par abrasion et polissage, la structure métallique et le moule de façon à obtenir une surface supérieure plane dont les irrégularités de surface ne dépassent pas 1 µm environ. Cette solution présente l'avantage de permettre une meilleure maîtrise de l'épaisseur dans la mise en oeuvre du procédé et d'améliorer la qualité de la structure obtenue car le dépôt électrolytique ultérieur s'effectue de façon plus régulière sur une surface plane polie que sur une surface présentant des irrégularités.

On utilise fréquemment comme métal pour l'électroformage le nickel, le cuivre, l'or ou l'argent, et comme alliage l'or-cuivre, le nickel-cobalt, le nickel-fer, le nickel-manganèse et le nickel-phosphore. Les conditions d'électroformage, notamment la composition des bains, la géométrie du système, les tensions et densités de courant, sont choisis pour chaque métal ou alliage à électrodéposer selon les techniques bien connues dans l'art de l'électroformage (cf. par exemple Di Bari G.A. "electroforming" Electroplating Engineering Handbook" 4th Edition rédigé par L.J. Durney, édité par Van Nostrand Reinhold Compagny Inc., N.Y. USA 1984).

L'étape g) consiste à déposer par vaporisation sous vide une couche de métal, appelée ici couche métallique d'accrochage, sur toute la surface supérieure plane, puis à reproduire les étapes a), b), c), d) et e).

Cette vaporisation sous vide (PVD) peut se faire dans les conditions habituelles bien connues dans l'art antérieur(cf. par exemple Donald M. Mattox, 1998, "Handbook of Physical Vapor Deposition (PVD) Processing" publié par William Andrew Publishing).

L'épaisseur de la couche métallique d'accrochage est en général de 50 à 500 nm, de préférence de 100 à 300 nm, en particulier de 120 à 250 nm.

Le métal vaporisé est choisi en fonction du métal d'électroformage pour sa capacité d'accrocher au métal électroformé et au photorésist d'une part, d'ensemencer la réaction d'électrodéposition d'autre part. Il peut être par exemple du nickel, du cuivre, de l'or, du chrome sur de l'or ou du nickel sur du titane.

Au cours de l'étape g), les étapes a), b), c), d) et e) sont effectuées de façon semblable à ce qui est décrit ci-dessus pour ces étapes, avec comme substrat dans l'étape a) la couche métallique d'accrochage et en utilisant un nouveau masque correspondant à l'empreinte désirée pour la nouvelle couche. On obtient ainsi un deuxième moule de photorésist polymérisé.

L'étape h) consiste à déposer galvaniquement une deuxième couche d'un métal ou d'un alliage dans les parties ouvertes du deuxième moule, en présence de la couche métallique d'accrochage, et usiner une surface supérieure sensiblement plane. La présence de la couche métallique d'accrochage permet d'assurer une croissance verticale du métal déposé et d'éviter la formation de bulles même quand la deuxième couche n'est pas entièrement superposée à la première couche. Le métal ou l'alliage de la deuxième couche peut être identique à celui, ou différent de celui, de la première couche. En général il s'agit du même métal ou alliage.

L'étape i) consiste à reproduire, si nécessaire, les étapes g) et h), de façon à obtenir la structure métallique multicouche souhaitée. Cette reproduction n'est pas nécessaire pour la fabrication d'une structure métallique bicouche.

L'étape j) consiste à détacher du substrat par délaminage la structure métallique multicouche obtenue et le photorésist polymérisé, séparer le photorésist de façon à libérer la structure métallique multicouche, puis éliminer la partie de la ou des couches métalliques d'accrochage qui n'est pas insérée entre deux couches de métal ou alliage électrodéposé.

La face inférieure de la structure métallique détachée par délaminage de la face supérieure du substrat métallique massif reproduit l'état de surface de celle-ci. Elle sera ainsi soit texturée (si la face supérieure du substrat métallique est texturée, par exemple par gravage ou microbillage) soit d'aspect poli (si la face supérieure du substrat métallique a subi un polissage). Dans ce dernier cas, à l'observation à l'oeil nu, l'aspect poli de la surface de la face inférieure de la structure ne se distingue pas de l'aspect poli obtenu le cas échéant par polissage sur la surface de la face supérieure. Par observation au microscope optique avec un grossissement de 50 fois, un éclairage adapté et une certaine orientation, ou au microscope électronique à balayage, ou à l'aide de systèmes topographiques d'analyse de surface, on parvient toutefois à distinguer ces deux surfaces.

La séparation ou le stripage du photorésist se fait en général par attaque chimique ou traitement plasmatique. Le traitement plasmatique permet d'avoir une action directive, ce qui permet en particulier de bien enlever la résine des trous borgnes par exemple, ce que ne garantit pas l'attaque chimique. En outre, le fait que ce traitement s'applique sur l'ensemble des structures liées les unes aux autres suite au délaminage, permet de maintenir toutes les structures dans une même orientation par rapport à la source de plasma et de traiter ainsi des parties préférentielles des structures.

Après le stripage du photorésist, une partie de la ou des couches métalliques d'accrochage n'est pas insérée entre deux couches de métal électroformé et doit donc être éliminée. Cette élimination s'effectue en général par attaque de ce métal dans un bain approprié qui n'attaque pas le métal électroformé. Par exemple lorsque la couche métallique d'accrochage est de l'or, cette élimination se fait dans un bain de dédorage à base d'une solution cyanurée.

Le procédé de l'invention peut aussi être utilisé pour fabriquer une structure métallique multicouche comportant une couche de métal ou d'alliage entièrement superposée sur ladite deuxième couche et/ou une couche de métal ou d'alliage sur laquelle ladite première couche est entièrement superposée. Le métal ou l'alliage de la couche entièrement superposée sur ladite deuxième couche peut être identique à celui, ou différent de celui, de ladite deuxième couche, et le métal ou l'alliage de la couche sur laquelle ladite première couche est entièrement superposée peut être identique à celui, ou différent de celui, de ladite première couche. En général, pour chacun de ces cas, il s'agit du même métal ou alliage.

Selon un mode d'exécution du procédé de l'invention, à l'issue de l'étape h) ou de l'étape i) et avant l'étape j), on réalise par LIGA-UV une couche de métal ou d'alliage entièrement superposée sur la couche de métal ou d'alliage déposée en h) ou en i). L'homme du métier trouvera dans l'art antérieur, et en particulier dans Frazier et al. cité ci-dessus, les conditions de dépôt d'une couche métallique entièrement superposée à une couche métallique. Celles-ci peuvent être par exemple les suivantes : on reproduit les étapes a), b), c), d) et e), puis on active par traitement électrochimique la surface du métal électroformé non recouverte de photorésist polymérisé, et on reproduit l'étape h). Cette activation se fait par application d'un courant inverse en faisant jouer au métal électroformé le rôle d'anode selon les techniques bien connues dans l'art du traitement des surfaces. On obtient ainsi un structure métallique multicouche comportant au moins une deuxième couche adjacente à une première couche et non entièrement superposée à celle-ci et une autre couche entièrement superposée à ladite deuxième couche

Selon un autre mode d'exécution du procédé de l'invention, préalablement à l'étape a), on a réalisé par LIGA-UV une couche de métal ou d'alliage sur laquelle ladite première couche de métal ou d'alliage est entièrement superposée. L'homme du métier trouvera dans l'art antérieur, et en particulier dans Frazier et al. cité ci-dessus, les conditions de dépôt d'une couche métallique entièrement superposée à une couche métallique. Les conditions de ce dépôt peuvent être par exemple les suivantes : on effectue les étapes a), b), c), d) et e), puis on active par traitement électrochimique la surface du métal électroformé non recouverte de photorésist polymérisé, et on effectue l'étape h). On obtient ainsi une structure métallique multicouche comportant au moins une deuxième couche adjacente à une première couche et non entièrement superposée à celle-ci et une autre couche sur laquelle ladite première couche est entièrement superposée.

Le procédé de l'invention permet de fabriquer par LIGA-UV des structures métalliques comportant au moins une deuxième couche adjacente à une première couche et non entièrement superposée à celle-ci, qui n'ont pas de défauts dus à la formation de bulles et à une croissance non verticale du métal électroformé. Des structures d'une telle qualité ne pouvaient pas être obtenues avec les procédés connus.

L'invention concerne ainsi également une nouvelle structure métallique multicouche comportant au moins une deuxième couche adjacente à une première couche et non entièrement superposée à celle-ci, susceptible d'être obtenue par le procédé défini ci-dessus.

D'autres particularités et avantages de l'invention apparaîtront à la lecture de la description détaillée qui va suivre, en référence aux dessins annexés, qui illustrent schématiquement et à titre d'exemple, quelques formes d'exécution du procédé de l'invention.

Dans ces dessins:
les figures 1A à 1C sont respectivement une vue en perspective de dessous, une vue en perspective de dessus et une vue en coupe selon la ligne AB de la vue en perspective de dessous, d'une structure bicouche à couches non entièrement superposées et à trous borgnes;
les figures 2A à 2I sont des vues en coupe représentant les différentes étapes de la fabrication de la structure bicouche des Figures 1A à 1C,
les figures 3A et 3B sont respectivement une vue en coupe et une vue de dessus d'un doigt de quantième, structure bicouche à couches non entièrement superposées,
les figures 4A et 4B sont respectivement une vue en coupe et une vue de dessus d'une entretoise, structure tricouche à deuxième couche non entièrement superposée sur la première couche et troisième couche entièrement superposée sur la deuxième couche.

Les exemples ci-après décrivent la fabrication selon le procédé de l'invention de cette structure bicouche, ce doigt de quantième et cette entretoise, en référence à ces figures.

### Exemple 1 : Fabrication d'une structure bicouche à trous borgnes

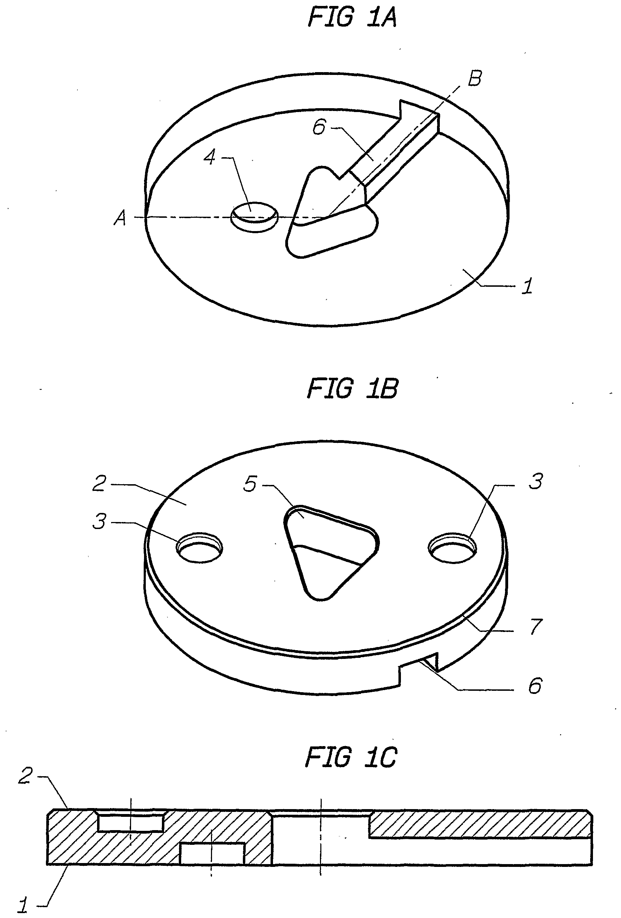

Les figures 1A, 1B et 1C représentent une structure bicouche comprenant une face inférieure 1, une face supérieure 2, deux trous borgnes 3 sur sa face supérieure, un trou borgne 4 sur sa face inférieure, un trou de forme 5, un dégagement 6 et des parties anglées 7.

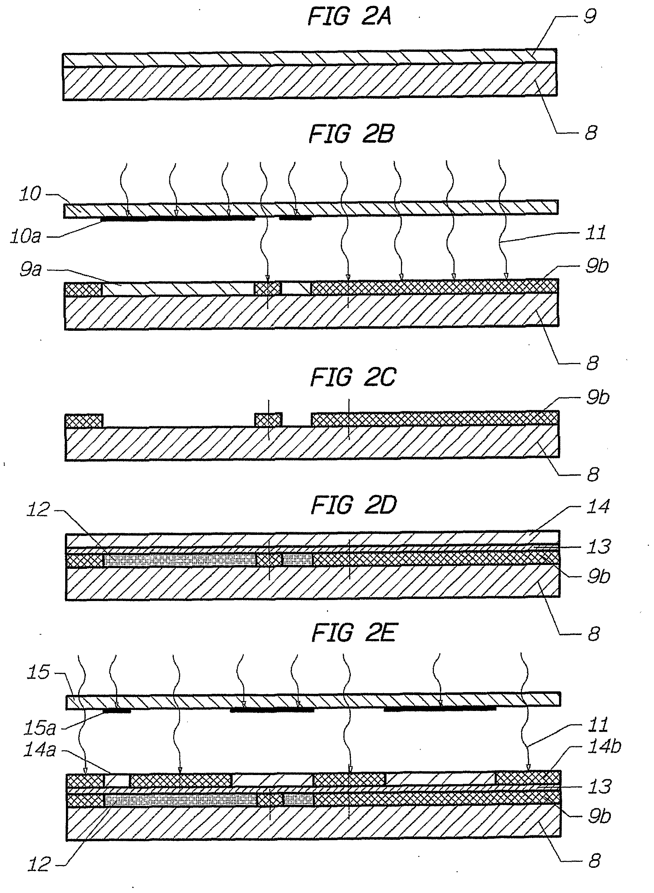

A la Figure 2A on a représenté la structure obtenue à l'issue de l'étape b), qui comprend une couche de photorésist 9 recouvrant le substrat 8. Cette structure a été obtenue selon le protocole décrit ci-après.

Un substrat 8 formé d'une plaquette en acier inox de 1 mm d'épaisseur et de 150 mm de diamètre, a été dégraissé et préparé pour l'électroformage par dégraissage avec une solution alcaline, suivi d'une neutralisation en milieu acide pour passiver sa surface, puis rinçage à l'eau distillée et séchage. On a ensuite procédé à l'étalement sur le substrat 8 par dépôt à la tournette d'une première couche de photorésist négatif à base de résine époxy octofonctionelle SU-8-2100(Shell Chemical) de 140 µm d'épaisseur, puis au chauffage pour évaporation du solvant pendant 5 minutes à 65 °C, puis 35 minutes à 95 °C. On a ensuite procédé à l'étalement sur la première couche de photorésist par dépôt à la tournette d'une deuxième couche du même photorésist de 140 µm d'épaisseur, puis au chauffage pour évaporation du solvant pendant 7 minutes à 65 °C, puis 60 minutes à 95°C.

La figure 2B correspond à l'étape c) d'illumination UV d'environ 600 mJ/cm² centrée à 365 nm du photorésist à travers un masque correspondant à l'empreinte désirée. On distingue sur cette figure le masque comportant un support 10 transparent aux UV 11 et des zones opaques 10a formées par des dépôts de chrome. Le même support formant le masque peut comporter un grand nombre de zones correspondant à autant de structures pouvant être fabriquées en un seul lot, toutes les zones étant obtenues avec une très haute résolution du contour par photolithographie, technique bien connue dans l'industrie microélectronique.

Cette irradiation induit la photo polymérisation de la résine dans les zones exposées 9b, les zones non exposées 9a restant non polymérisées.

La Figure 2C montre la structure obtenue à l'issue de l'étape e).

On a effectué un recuit de la couche obtenue à l'issue de l'étape c) pour compléter la polymérisation pendant 2 minutes à 65 °C, puis 20 minutes à 95 °C, puis dissolution du photorésist non exposé par passage de 20 minutes dans trois bains successifs de PGMEA (de pureté croissante), rinçage dans un bain d'alcool isopropylique et séchage. On distingue dans la Figure 2C le moule 9b en photorésist polymérisé superposé sur le substrat 8.

La figure 2D montre la structure obtenue après réalisation de l'étape f) et la reproduction selon l'étape g) des étapes a) et b).

On a effectué au cours de l'étape f) le dépôt galvanique de nickel dans les parties ouvertes du moule de photorésist polymérisé, et une mise à niveau par abrasion et polissage de façon à obtenir une surface supérieure plane, puis déposé par vaporisation sous vide une couche d'accrochage d'or d'environ 200 nm et reproduit les étapes a) et b) avec deux couches successives de 125 µm du même photorésist à base de résine époxy SU-8-2100, chauffage pendant 5 minutes à 65 °C puis 35 minutes à 95 °C pour la première couche, et chauffage pendant 7 minutes à 65 °C puis 60 minutes à 95 °C pour la deuxième couche.

On distingue sur la Figure 2D la couche de photorésist 14 au-dessus de la couche d'or 13 recouvrant le photorésist polymérisé 9b et la couche électroformée 12, au-dessus du substrat 8.

La figure 2E correspond à la reproduction de l'étape c) avec une illumination UV d'environ 550 mJ/cm² centrée à 365 nm, du photorésist à travers un nouveau masque correspondant à l'empreinte désirée. On distingue sur cette figure le masque comportant un support 15 transparent aux UV et des zones opaques 15a formées par des dépôts de chrome. Cette irradiation par rayons UV 11 induit la photo polymérisation de la résine dans les zones exposées 14b, les zones non exposées 14a restant non polymérisées.

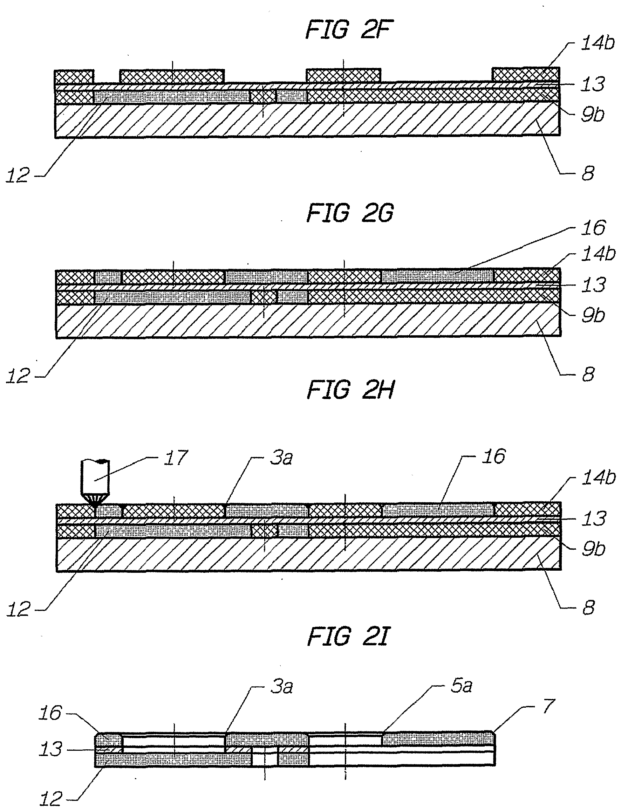

La Figure 2F montre la structure obtenue à l'issue de l'étape g). On a effectué un recuit de la couche obtenue à l'issue de la reproduction de l'étape c) pour compléter la polymérisation pendant 1 minute à 65 °C, puis 15 minutes à 95 °C, puis dissout le photorésist non exposé par passage pendant 15 minutes dans trois bains successifs de PGMEA (de pureté croissante), rinçage dans un bain d'alcool isopropylique et séchage. On distingue dans cette figure le deuxième moule de photorésist polymérisé 14b au-dessus de la couche métallique d'accrochage 13, au-dessus du premier moule de photorésist polymérisé 9b et la couche de nickel électroformé 12, au-dessus du substrat 8.

La figure 2G montre la structure obtenue à l'issue de l'étape h). On a effectué un deuxième dépôt galvanique de nickel jusqu'à une hauteur légèrement supérieure (de 10 à 30 µm) à l'épaisseur visée, puis une mise à niveau par abrasion et polissage de façon à obtenir une surface supérieure plane. On distingue sur cette figure le deuxième moule de résine polymérisée 14b et la deuxième couche électroformée 16, au-dessus de la couche métallique d'accrochage 13, au-dessus du premier moule polymérisé 9b et de la première couche électroformée 12, au-dessus du substrat 8.

La figure 2H montre une opération d'anglage effectuée sur la structure obtenue à l'issue de l'étape h). On distingue sur cette figure (de plus par rapport à la figure 2G) une fraise 17 et un trou anglé 3a.

La figure 2I, qui correspond à la vue en coupe de la figure 1C, montre la structure bicouche à trous borgnes obtenue à l'issue de l'étape j), après détachage du substrat métallique par délaminage, élimination du photorésist polymérisé par un traitement plasmatique et stripage par dédorage de la partie de la couche d'or non insérée entre les deux couches de nickel électrodéposé. On distingue sur cette figure la première couche de nickel 12, la couche d'or 13, la deuxième couche de nickel 16, et les anglages 3a, 5a et 7.

Le délaminage des structures métalliques électrodéposées permet de les tenir ensemble avec la résine qui les relie. Grâce à ce mode de séparation des structures, il est alors possible de retourner toutes les structures ensemble et de les soumettre à un traitement plasmatique, lequel, en raison de sa directivité permet de supprimer toute la résine qui se trouve en face de la source du plasma. Ce mode d'enlèvement de la résine permet notamment de vider complètement les trous borgnes et autres parties des structures métalliques difficiles à atteindre en trempant simplement des structures en vrac dans un bain, notamment lorsque le trou borgne a un très faible diamètre, comme dans le cas du trou 4 de la figure 1C.

Compte tenu de ce qui précède, on peut adopter la suite d'opérations suivante pour éviter un traitement en vrac des structures lors de la suppression de la couche d'accrochage d'or :
1) Opération d'anglage à l'aide de la fraise 17 (fig. 2H) ;
2) Elimination du photorésist 14b par traitement plasmatique;
3) Stripage par dédorage des parties de la couche 13 non situées entre les couches 12 et 16;
4) Détachage de la structure métallique multicouche du substrat par délaminage;
5) Séparation du photorésist 9b par traitement plasmatique.

### Exemple 2 : Fabrication d'un doigt de quantième

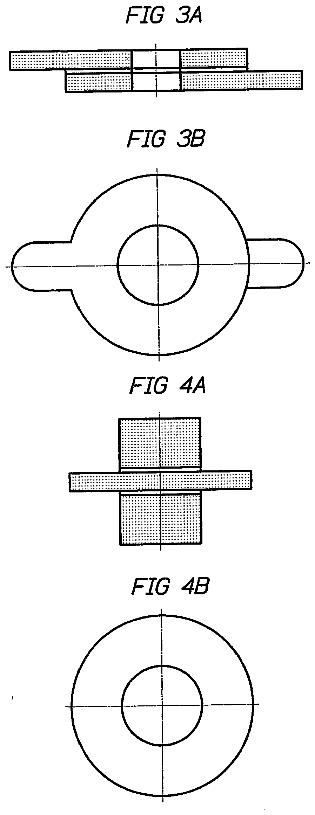

Le doigt de quantième représenté par les figures 3A et 3B a été préparé comme décrit ci-dessous.

Un substrat formé d'une plaquette en acier inox de 1 mm d'épaisseur et de 150 mm de diamètre, a été dégraissé et préparé pour l'électroformage par dégraissage avec une solution alcaline, suivi d'une neutralisation en milieu acide pour passiver sa surface, puis rinçage à l'eau distillée et séchage. On a ensuite procédé à l'étalement sur le substrat par dépôt à la tournette d'une première couche de photorésist négatif à base de résine époxy octofonctionelle SU-8-2100 (Shell Chemical) de 140 µm d'épaisseur, puis au chauffage pour évaporation du solvant pendant 5 minutes à 65 °C, puis 35 minutes à 95 °C. On a ensuite procédé à l'étalement sur la première couche de photorésist par dépôt à la tournette d'une deuxième couche du même photorésist de 140 µm d'épaisseur, puis au chauffage pour évaporation du solvant pendant 7 minutes à 65 °C, puis 60 minutes à 95°C.

On a ensuite effectué l'étape c) avec une illumination UV d'environ 750 mJ/cm² centrée à 365 nm du photorésist à travers un masque correspondant à l'empreinte désirée. Cette irradiation induit la photo polymérisation de la résine dans les zones exposées, les zones non exposées restant non polymérisées.

On a ensuite effectué un recuit de la couche obtenue pour compléter la polymérisation pendant 2 minutes à 65 °C, puis 20 minutes à 95 °C, puis on a dissout le photorésist non exposé par passage pendant 20 minutes dans trois bains successifs de PGMEA (de pureté croissante), rinçage dans un bain d'alcool isopropylique et séchage. On a ainsi obtenu un moule de photorésist polymérisé au-dessus du substrat en inox.

On a ensuite effectué le dépôt galvanique de nickel dans les parties ouvertes du moule de photorésist polymérisé, et une mise à niveau par abrasion et polissage de façon à obtenir une surface supérieure plane, déposé par vaporisation sous vide une couche d'or d'environ 200 nm et reproduit les étapes a) et b) avec deux couches successives de 120 µm du même photorésist à base de résine époxy SU-8-2100, chauffage pendant 5 minutes à 65°C puis 35 minutes à 95°C pour la première couche, et chauffage pendant 7 minutes à 65°C puis 60 minutes à 95°C pour la deuxième couche.

On a ensuite reproduit l'étape c) avec une illumination UV d'environ 700 mJ/cm² centrée à 365 nm, du photorésist à travers un nouveau masque correspondant à l'empreinte désirée. Cette irradiation par rayons UV induit la photo polymérisation de la résine dans les zones exposées, les zones non exposées restant non polymérisées.

On a ensuite effectué un recuit pour compléter la polymérisation pendant 1 minute à 65°C, puis 15 minutes à 95°C, puis dissout le photorésist non exposé par passage pendant 15 minutes dans trois bains successifs de PGMEA (de pureté croissante), rinçage dans un bain d'alcool isopropylique et séchage. On a ainsi obtenu un deuxième moule de photorésist polymérisé, au-dessus de la couche d'or d'accrochage, au-dessus du premier moule de photorésist polymérisé et de la couche de nickel électroformé, au-dessus du substrat.

On a ensuite effectué un deuxième dépôt galvanique de nickel jusqu'à une hauteur légèrement supérieure à l'épaisseur visée (de 10 à 30 µm), puis mis à niveau par abrasion et polissage de façon à obtenir une surface supérieure plane.

On a ensuite détaché le substrat de la structure métallique par délaminage, éliminé le photorésist polymérisé par un traitement plasmatique et éliminé la couche d'or en contact avec l'extérieur par dédorage. On a ainsi obtenu le doigt de quantième représenté sur les Figures 3A et 3B.

### Exemple 3 : Fabrication d'une entretoise

Pour fabriquer l'entretoise illustrée par les figures 4A et 4B, on prend un substrat formé d'une plaquette en acier inox de 1 mm d'épaisseur et de 150 mm de diamètre, que l'on dégraisse et prépare pour l'électroformage avec une solution alcaline suivi d'une neutralisation avec une solution acide pour passiver sa surface, puis rinçage à l'eau distillée et séchage. On a ensuite procédé à l'étalement sur le substrat par dépôt à la tournette d'une première couche de photorésist négatif à base de résine époxy octofonctionelle SU-8-2100(Shell Chemical) de 140 µm d'épaisseur, puis au chauffage pour évaporation du solvant pendant 5 minutes à 65°C, puis 35 minutes à 95°C. On a ensuite procédé à l'étalement sur la première couche de photorésist par dépôt à la tournette d'une deuxième couche du même photorésist de 140 µm d'épaisseur, puis au chauffage pour évaporation du solvant pendant 7 minutes à 65°C, puis 60 minutes à 95°C.

On a ensuite effectué l'étape c) avec une illumination UV d'environ 600 mJ/cm² centrée à 365 nm du photorésist à travers un masque correspondant à l'empreinte désirée. Cette irradiation induit la photo polymérisation de la résine dans les zones exposées, les zones non exposées restant non polymérisées.

On a ensuite effectué un recuit de la couche obtenue pour compléter la polymérisation pendant 1 minutes à 65°C, puis 15 minutes à 95°C, puis on a dissout le photorésist non exposé par passage pendant 20 minutes dans trois bains successifs de PGMEA (de pureté croissante), rinçage dans un bain d'alcool isopropylique et séchage. On a ainsi obtenu un moule de photorésist polymérisé au-dessus du substrat en inox.

On a ensuite effectué le dépôt galvanique de nickel dans les parties ouvertes du moule de photorésist polymérisé, et une mise à niveau par abrasion et polissage de façon à obtenir une surface supérieure plane, déposé par vaporisation sous vide une couche d'or d'environ 150 nm et reproduit les étapes a) et b) avec deux couches successives de 90 µm du même photorésist à base de résine époxy SU-8-2100, chauffage pendant 5 minutes à 65°C puis 20 minutes à 95°C pour la première couche, et chauffage pendant 60 minutes à 45°C puis 60 minutes à 95°C pour la deuxième couche.

On a ensuite reproduit l'étape c) avec une illumination UV d'environ 500 mJ/cm² centrée à 365 nm, du photorésist à travers un nouveau masque correspondant à l'empreinte désirée. Cette irradiation par rayons UV induit la photopolymérisation de la résine dans les zones exposées, les zones non exposées restant non polymérisées.

On a ensuite effectué un recuit pour compléter la polymérisation pendant 1 minute à 65°C, puis 15 minutes à 95°C, puis dissout le photorésist non exposé par passage pendant 15 minutes dans trois bains successifs de PGMEA (de pureté croissante), rinçage dans un bain d'alcool isopropylique et séchage. On a ainsi obtenu un deuxième moule de photorésist polymérisé, au-dessus de la couche d'or d'accrochage, au-dessus du premier moule de photorésist polymérisé et de la couche de nickel électroformé, au-dessus du substrat.

On a ensuite effectué un deuxième dépôt galvanique de nickel jusqu'à une hauteur légèrement supérieure (de 10 à 30 µm) à la hauteur visée, puis mis à niveau par abrasion et polissage de façon à obtenir une surface supérieure plane.

On a reproduit les étapes a) et b) avec deux couches successives de 140 µm du même photorésist à base de résine époxy SU-8-2100, chauffage pendant 5 minutes à 65°C puis 35 minutes à 95°C pour la première couche, et chauffage pendant 7 minutes à 45°C puis 60 minutes à 95°C pour la deuxième couche.

On a ensuite reproduit l'étape c) avec une illumination UV d'environ 600 mJ/cm² centrée à 365 nm, du photorésist à travers un nouveau masque correspondant à l'empreinte désirée. Cette irradiation par rayons UV induit la photo polymérisation de la résine dans les zones exposées, les zones non exposées restant non polymérisées.

On a ensuite effectué un recuit pour compléter la polymérisation pendant 1 minute à 65°C, puis 15 minutes à 95°C, puis dissout le photorésist non exposé par passage pendant 15 minutes dans trois bains successifs de PGMEA (de pureté croissante), rinçage dans un bain d'alcool isopropylique et séchage. On a ainsi obtenu un troisième moule de photorésist polymérisé au-dessus du premier de la deuxième couche de nickel électroformé.

On a activé par traitement électrochimique la surface supérieure de cette deuxième couche de nickel électroformée non recouverte de photorésist polymérisé.

On a ensuite effectué un troisième dépôt galvanique de nickel jusqu'à une hauteur légèrement supérieure (de 10 à 30 µm) à celle de la hauteur visée, puis une mise à niveau par abrasion et polissage de façon à obtenir une surface supérieure plane.

Dans la mesure où la troisième couche de nickel électrodéposée est entièrement superposée à la deuxième, la couche d'accrochage intermédiaire peut être supprimée.

On a ensuite détaché le substrat de la structure métallique par délaminage, éliminé le photorésist polymérisé par un traitement plasmatique et éliminé la couche d'or en contact avec l'extérieur par dédorage. On a ainsi obtenu l'entretoise représentée sur les Figures 4A et 4B.

## Revendications

1. Procédé de fabrication par LIGA-UV d'une structure métallique multicouche comportant une première couche (12) ayant un trou (4) ou un dégagement (6), au moins une deuxième couche (16) adjacente à une première couche, non entièrement superposée à celle-ci et surplombant ledit trou (4) ou dégagement (6), qui comprend les étapes suivantes :
a) étaler une couche de photorésist (9) sur un substrat plat en métal massif (8),
b) chauffer la couche de photorésist (9), si nécessaire pour évaporer le solvant,
c) exposer la couche de photorésist (9) à travers un masque (10) correspondant à l'empreinte désirée à une irradiation,
d) effectuer, si nécessaire pour compléter la photopolymérisation ou la photodécomposition des parties irradiées (9b), un recuit de la couche (9) obtenue à l'issue de l'étape c),
e) procéder au développement par dissolution des parties non photopolymérisées ou photodécomposées (9a), de façon à obtenir un moule de photorésist polymérisé,
f) déposer galvaniquement une première couche (12) d'un métal ou d'un alliage dans les parties ouvertes du moule, et mettre à niveau par usinage la structure métallique,
g) reproduire les étapes a), b), c), d) et e),
h) déposer galvaniquement une deuxième couche (16) d'un métal ou d'un alliage, et mettre à niveau par usinage la structure métallique et le moule de façon à obtenir une surface supérieure plane,
i) reproduire, si nécessaire, les étapes g) et h), de façon à former la structure métallique multicouche souhaitée, et
j) détacher du substrat par délaminage la structure métallique multicouche obtenue et le photorésist polymérisé, séparer le photorésist de façon à libérer la structure métallique multicouche,
**caractérisé en ce que**
- à l'étape c), l'irradiation est une irradiation UV de 100 à 2000 mJ/cm² mesurée à une longueur d'onde de 365 nm,
- à l'étape f), la mise à niveau s'effectue avec le moule, puis une couche métallique d'accrochage est déposée par vaporisation sous vide sur toute la surface supérieure plane et
- à la fin de l'étape j), on élimine la partie de la ou des couches métalliques d'accrochage (13) qui n'est pas insérée entre deux couches de métal électrodéposé (12,16).

2. Procédé selon la revendication 1, **caractérisé en ce qu'**à l'issue de l'étape h) ou de l'étape i), et avant l'étape j), on réalise par LIGA-UV une couche de métal ou d'alliage entièrement superposée sur la couche de métal ou d'alliage déposée en h) ou en i).

3. Procédé selon l'une des revendications précédentes, **caractérisé en ce que** préalablement à l'étape a), on a réalisé par LIGA-UV une couche de métal ou d'alliage sur laquelle ladite première couche de métal ou d'alliage est entièrement superposée.

4. Procédé selon l'une des revendications précédentes, **caractérisé en ce que** le substrat est une plaquette en acier inoxydable.

5. Procédé selon l'une des revendications précédentes **caractérisé en ce que** le substrat a une surface supérieure texturée, par microbillage, gravage chimique, mécanique ou par laser.

6. Procédé selon l'une des revendications précédentes, **caractérisé en ce que** le substrat a une surface supérieure polie.

7. Procédé selon l'une des revendications précédentes **caractérisé en ce que** on forme simultanément une pluralité de structures métalliques multicouches sur le même substrat plat en métal massif et après l'étape i), on élimine de manière directionnelle au moins le photorésist polymérisé accessible de l'avers de ladite pluralité de structures par un traitement plasmatique et on élimine les parties non recouvertes de la couche métallique d'accrochage.

8. Structure métallique multicouche comportant au moins une deuxième couche adjacente à une première couche et non entièrement superposée à celle-ci susceptible d'être obtenue selon l'une des revendications 1 à 7.

9. Structure métallique selon la revendication 8 **caractérisée en ce qu'**elle est une pièce d'horlogerie.

## Patentansprüche

1. LIGA-UV Herstellungsverfahren einer mehrschichtigen, metallischen Struktur umfassend eine erste, ein Loch (4) oder eine Ausnehmung (6) umfassende Schicht (12), mindestens eine zweite Schicht (16) angrenzend an eine erste Schicht, wobei sie diese nicht vollständig überlagert und das genannte Loch (4) oder die Ausnehmung (6) überragt, wobei das Verfahren die folgenden Schritte umfasst:
a) Aufbringen einer Photoresist-Schicht (9) auf ein ebenes Substrat aus massivem Metall (8),
b) Erhitzen der Photoresist-Schicht (9), wenn notwendig, um das Lösungsmittel verdampfen zu lassen,
c) die Photoresist-Schicht (9) einer Bestrahlung aussetzen durch eine Maske (10), die dem gewünschten Abdruck entspricht,
d) Ausglühen der in Schritt c) erhaltenen Schicht (9) wenn notwendig, um die Photopolymerisation oder die Photozersetzung der bestrahlten Teile (9b) abzuschließen,
e) Entwickeln durch Auflösen der nicht photopolymerisierten oder photozersetzten Teile (9a), in der Weise, dass eine polymerisierte Photoresist-Form erhalten wird,
f) galvanisches Aufbringen einer ersten Schicht (12) aus Metall oder aus einer Legierung in die offenen Bereiche der Form, und Angleichen der metallischen Struktur durch Bearbeiten,
g) Wiederholen der Schritte a), b), c), d) und e),
h) galvanisches Aufbringen einer zweiten Schicht (16) eines Metalls oder einer Legierung in der Weise, und Angleichen der metallischen Struktur und der Form durch Bearbeiten, in der Weise, dass eine ebene obere Oberfläche erhalten wird,
i) Wiederholen, wenn notwendig, der Schritte g) und h), in der Weise, dass die gewünschte metallischen Mehrschicht-Struktur gebildet wird,
j) Ablösen der erhaltenen metallischen Mehrschicht-Struktur und des polymerisierten Photoresists vom Substrat durch Delamination, Trennen des Photoresists in der Weise, dass die metallischen Mehrschicht-Struktur freigelegt wird,
**dadurch gekennzeichnet, dass**
- bei dem Schritt c) die Bestrahlung eine UV-Bestrahlung von 100 bis 2000 mJ/cm² gemessen bei einer Wellenlänge von 365 nm ist,
- bei dem Schritt f) die Angleichung mit der Form ausgeführt wird, dann eine metallische Grundschicht durch Vakuumverdampfung auf die gesamte obere ebene Oberfläche aufgetragen wird und
- am Ende bei dem Schritt j) der Teil der Grundschicht oder der Grundschichten (13) entfernt wird, der nicht zwischen den beiden galvanischen Metallschichten (12, 16) eingeschlossen ist.

2. Verfahren gemäß Anspruch 1, **dadurch gekennzeichnet, dass** man nach Abschluss des Schrittes h) oder des Schrittes i) und vor Beginn des Schrittes j) eine Schicht aus Metall oder aus einer Legierung mittels LIGA-UV aufbringt, die die in Schritt h) oder in i) aufgebrachte Schicht aus Metall oder aus einer Legierung vollständig überlagert.

3. Verfahren gemäß einem der vorangehenden Ansprüche, **dadurch gekennzeichnet, dass** man im Vorlauf zu Schritt a) mittels LIGA-UV eine Schicht aus Metall oder aus einer Legierung geschaffen hat, welche von der genannten ersten Schicht aus Metall oder aus einer Legierung vollständig überlagert wird.

4. Verfahren gemäß einem der vorangehenden Ansprüche, **dadurch gekennzeichnet, dass** das Substrat ein Plättchen aus rostfreiem Stahl ist.

5. Verfahren gemäß einem der vorangehenden Ansprüche, **dadurch gekennzeichnet, dass** das Substrat eine obere Oberfläche aufweist, die texturiert ist, durch Perlstrahlen, chemische, mechanische, oder Laser-Gravur.

6. Verfahren gemäß einem der vorangehenden Ansprüche, **dadurch gekennzeichnet, dass** das Substrat eine polierte obere Oberfläche aufweist.

7. Verfahren gemäß einem der vorangehenden Ansprüche, **dadurch gekennzeichnet, dass** man gleichzeitig eine Vielzahl von mehrschichtigen, metallischen Strukturen auf demselben flachen Substrat aus massivem Metall bildet und man nach Schritt i) in gerichteter Weise zumindest das von der Vorderfläche der Vielzahl der Strukturen zugängliche polymerisierte Photoresist durch eine plasmatische Behandlung entfernt und man nicht bedeckte Teile der metallischen Grundschicht entfernt.

8. Mehrschichtige metallische Struktur umfassend mindestens eine zweite Schicht angrenzend an eine erste und diese nicht vollständig überlagernd, herstellbar durch ein Verfahren gemäß einem der Ansprüche 1 bis 7.

9. Metallische Struktur gemäß Anspruch 8, **dadurch gekennzeichnet, dass** sie ein Zeitmessgerät ist.

## Claims

1. A process for the UV-LIGA fabrication of a multilayer metal structure comprising a first layer (12) having a hole (4) or a recess (6), at least a second layer (16) adjacent to a first layer, not entirely superposed therewith and directly above said hole (4) or recess (6), which process comprises the following steps:
a) a photoresist layer (9) is spread over a flat substrate made of solid metal (8),
b) the photoresist layer (9) is heated, if necessary to evaporate the solvent,
c) the photoresist layer (9) is exposed to an irradiation through a mask (10) corresponding to the desired impression,
d) if necessary to complete the photocuring or photodecomposition of the irradiated parts (9b), an annealing operation is carried out on the layer (9) obtained from the step c),
e) the development step is carried out, by dissolving the parts (9a) that have not undergone photocuring or photodecomposition, so as to obtain a cured photoresist mold,
f) a first layer (12) of a metal or alloy is galvanically deposited in the open parts of the mold, and the metal structure is leveled by machining,
g) steps a), b), c), d) and e) are repeated,
h) a second layer (16) of a metal or alloy is galvanically deposited, and the metal structure and the mold are leveled by machining so as to obtain a planar upper surface,
i) if necessary, steps g) and h) are repeated so as to form the desired multilayer metal structure; and
j) the multilayer metal structure obtained and the cured photoresist are detached from the substrate by delaminating, the photoresist is separated so as to free the multilayer metal structure
**characterized in that**,
- at step c), the irradiation is a UV irradiation of 100 to 2000 mJ/cm² measured at a wavelength from 365 nm,
- at step f), the metal structure and the mold are leveled by machining, then a metal tie layer is deposited by vacuum evaporation on the entire planar upper surface, and
- at the end of step j), that part of the metal tie layer or layers (13) which has not been inserted between two electrodeposited metal layers (12, 16) is removed.

2. The process as claimed in claim 1, **characterized in that** after step h) or step i), and before step j), a metal or alloy layer entirely superposed on the metal or alloy layer deposited in step h) or in step i) is produced by UV-LIGA.

3. The process as claimed in either of the preceding claims, **characterized in that**, prior to step a), a metal or alloy layer, on which said metal or alloy first layer is entirely superposed, is produced by UV-LIGA.

4. The process as claimed in one of the preceding claims, **characterized in that** the substrate is a stainless steel plate.

5. The process as claimed in one of the preceding claims, **characterized in that** the substrate has an upper surface that is textured by shot peening or by chemical, mechanical or laser etching.

6. The process as claimed in one of the preceding claims, **characterized in that** the substrate has a polished upper surface.

7. The process as claimed in one of the preceding claims, **characterized in that** a plurality of multilayer metal structures are formed simultaneously on the same solid metal flat substrate and, after step i), at least the cured photoresist accessible in the obverse side of said plurality of structures is removed directionally by a plasma treatment and the unexposed parts of the metal tie layer are removed.

8. A multilayer metal structure comprising at least a second layer adjacent to a first layer and not entirely superposed on the latter, which can be obtained as claimed in claims 1 to 7.

9. The metal structure as claimed in claim 8, **characterized in that** it is a timepiece component.
